# EUROPÄISCHE PATENTSCHRIFT

(11) **EP 0 504 233 B1**
(45) Veröffentlichungstag und Bekanntmachung des Hinweises auf die Patenterteilung: **27.04.1994**
(21) Anmeldenummer: 91900783.1
(22) Anmeldetag: 04.12.1990
(51) Int. Cl.: G01R 31/34

(54) **VERFAHREN UND EINRICHTUNG ZUR ÜBERPRÜFUNG DES ABSCHALT-DREHMOMENTES EINES STELLANTRIEBES**
PROCESS AND DEVICE FOR VERIFYING THE CUT-OFF TORQUE OF AN ACTUATOR
PROCEDE ET DISPOSITIF DE CONTROLE DU COUPLE DE DEBRANCHEMENT DE SERVO-MOTEURS

(30) Priorität: 14.12.1989 EP 89123148
(43) Veröffentlichungstag der Anmeldung: 23.09.1992
(73) Patentinhaber: SIEMENS AKTIENGESELLSCHAFT, 80333 München (DE)
(72) Erfinder: STECHER, Willi, D-8560 Lauf (DE)
(86) Internationale Anmeldenummer: EP9002092
(87) Internationale Veröffentlichungsnummer: WO9109319

(56) Entgegenhaltungen:
- DE-B- 1 200 571

## Beschreibung

Die Erfindung betrifft ein Verfahren zur Überprüfung des Abschalt-Drehmomentes eines Stellantriebes einer Armatur, der eine Abtriebswelle für die Armatur und einen Drehmoment-Endschalter aufweist. Sie betrifft auch eine Einrichtung zur Überprüfung des Abschalt-Drehmomentes.

Zur Überprüfung der Funktionsfähigkeit einer Armatur ist es erforderlich, daß in bestimmten Zeitabständen auch deren Stellantrieb überprüft wird. Dabei ist darauf zu achten, daß das Abschalt-Drehmoment des Stellantriebes den Anforderungen entspricht.

Bisher werden für die Überprüfung und Einstellung des Abschalt-Drehmomentes eines Stellantriebes stets stationäre Prüfstände verwendet, die wegen ihres Gewichts nicht transportiert werden können. Die Masse eines solchen Prüfstandes beträgt zwischen 100 kg und 200 kg. Zur Überprüfung wird daher der Stellantrieb von der Armatur abgenommen, und es werden die Versorgungsleitungen entfernt. Am stationären Prüfstand, der sich in der Regel in einem Werkstattraum befindet, erfolgt dann die Überprüfung des Abschalt-Drehmomentes. Nach Abschluß der Arbeiten, die auch ein Regulieren des Abschalt-Drehmomentes beinhalten können, wird der Stellantrieb zur Armatur zurückgebracht. Dort wird er mit der Armatur verbunden und auch die elektrischen Verbindungsleitungen werden an den Stellantrieb angeschlossen.

Eine Einrichtung zur Drehmomentüberprüfung eines Stellantriebes, die einen solchen stationären Prüfstand aufweist, ist aus der deutschen Auslegeschrift 1 200 571 bekannt. Dabei wird ein Prüfling, der ein Stellantrieb einer Armatur sein kann, überprüft. Da der Prüfstand vom Einsatzort des Prüflings relativ weit entfernt ist, müssen alle Leitungen, die an ihm enden oder von ihm ausgehen, entfernt werden. Der Prüfling wird dann während des Prüfvorgangs durch eine dazu notwendige besondere Maschine angetrieben.

Eine derartige Überprüfung eines Stellantriebes ist sehr zeitaufwendig. Während des gesamten Zeitraumes, während dessen sich der Stellantrieb nicht auf der Armatur befindet, kann die Armatur nicht betrieben werden. Dadurch ist die Verfügbarkeit derjenigen Anlage eingeschränkt, deren Teil die Armatur ist. Es können hohe Ausfallkosten, insbesondere in Kernkraftwerken, anfallen.

Der Erfindung liegt die Aufgabe zugrunde, ein Verfahren zur Überprüfung des Abschalt-Drehmomentes eines Stellantriebes anzugeben, das zuverlässig arbeitet und so schnell durchführbar ist, daß die Ausfallzeiten der Armatur und damit der gesamten Anlage deutlich kleiner sind als bei bisher üblichen Prüfverfahren. Dadurch soll es möglich sein, während eines üblichen Stillstandes der Anlage mehrere Stellantriebe zu überprüfen. Es soll auch eine Einrichtung angegeben werden, die eine solche schnelle Überprüfung möglich macht.

Die erstgenannte Aufgabe wird gemäß der Erfindung dadurch gelöst, daß der Stellantrieb unter Beibehaltung mindestens einer elektrischen Leitung, die am Stellantrieb endet oder von ihm ausgeht, von der Armatur abgehoben wird, daß mit der Abtriebswelle des Stellantriebs eine Drehmoment-Meßwelle und eine mit ihr verbundene Bremse verbunden wird, daß der Stellantrieb in unmittelbarer Nähe der Armatur in Betrieb genommen wird und anschließend bis zum Ansprechen des Drehmoment-Endschalters abgebremst wird und daß das dabei ermittelte Abschalt-Drehmoment mit einem Soll-Abschalt-Drehmoment verglichen wird.

Beispielsweise wird bis zum Ansprechen des Drehmoment-Endschalters der Verlauf des Drehmomentes gemessen und registriert.

Aus dem Verlauf kann man zusätzliche Informationen über den Zustand des Stellantriebes entnehmen. Außerdem wird das Ermitteln des Abschalt-Drehmomentes durch eine laufende Überwachung des Drehmomentes erleichtert.

Das Soll-Abschalt-Drehmoment kann zuvor rechnerisch ermittelt worden sein. Bei einer Abweichung des ermittelten Abschalt-Drehmomentes vom Soll-Abschalt-Drehmoment kann das Abschalt-Drehmoment nachjustiert werden.

Der von der Armatur getrennte Stellantrieb kann über nicht unterbrochene elektrische Leitungen weiterhin versorgt werden. Für einen Elektromotor des Stellantriebes ist also während einer Überprüfung keine eigene Spannungsquelle erforderlich. Auch kann eine vorhandene Auswerteeinheit verwendet werden.

Mit dem Verfahren nach der Erfindung wird der Vorteil erzielt, daß der Stellantrieb nicht vollständig von der Armatur entfernt werden muß, und daß ein Transport des Stellantriebes zu einer Prüfvorrichtung entfallen kann. Die Prüfung des Stellantriebes erfolgt direkt am Armaturenstandort mit der vorhandenen Anlagenverdrahtung. Dadurch bedingt ist eine zuverlässige Überprüfung in sehr kurzer Zeit durchführbar. Die Ausfallzeit einer Armatur für eine Überprüfung ist daher sehr klein, was relativ geringe Ausfallkosten zur Folge hat.

Beispielsweise wird der Stellantrieb an einem Hebezeug hängend von der Armatur abgehoben und so gehalten. In dieser Position wird er dann in Betrieb genommen und mit dem Verfahren nach der Erfindung geprüft. Die Prüfung erfolgt also, während der Stellantrieb am Hebezeug hängt. Die Prüfung kann dadurch in sehr kurzer Zeit abgeschlossen werden.

Nach einem anderen Beispiel wird der Stellantrieb von der Armatur abgehoben und mit nach oben gerichteter Abtriebswelle positioniert. Damit wird der Vorteil erzielt, daß der Stellantrieb während des Prüfvorganges in einer stabilen Lage verharrt.

In beiden Fällen bleibt die vorhandene Verdrahtung des Stellantriebes unverändert bestehen.

Die zweite Aufgabe, eine Einrichtung zur Überprüfung des Abschalt-Drehmomentes eines Stellantriebes einer Armatur anzugeben, der eine Abtriebswelle für die Armatur und einen Drehmoment-Endschalter aufweist, wobei diese Einrichtung geeignet sein soll, das zuvor genannte Verfahren durchzuführen, wird gemäß der Erfindung dadurch gelöst, daß mit der Abtriebswelle des von der Armatur getrennten Stellantriebes eine Drehmoment-Meßwelle, die mit einer Bremse verbunden ist, oder eine Bremse, die mit einer Drehmoment-Meßwelle verbunden ist, in unmittelbarer Nähe der Armatur verbunden ist und daß mindestens eine elektrische Leitung, die am Stellantrieb endet oder von ihm ausgeht, beibehalten bleibt.

Sowohl eine Drehmoment-Meßwelle, als auch eine Bremse sind bekannte Vorrichtungen, die käuflich erworben werden können. Die gestellte Aufgabe wird also dadurch gelöst, daß eine Kombination aus Drehmoment-Meßwelle und Bremse bereitgestellt wird, die Vorrichtungen aufweist, um sie an die Abtriebswelle des Stellantriebes unmittelbar nach dem Abtrennen des Stellantriebes von der Armatur anzukoppeln. Mit dieser Einrichtung wird der Vorteil erzielt, daß außerhalb eines Prüfstandes, unmittelbar am Ort der Armatur das Abschalt-Drehmoment eines Stellantriebes zu überprüfen ist. Die Einrichtung hat im Vergleich zu einem stationären Prüfstand nur ein geringes Gewicht. Ein bisher üblicher stationärer Prüfstand hat eine Masse von 100 kg bis 200 kg. Die Einrichtung nach der Erfindung hat hingegen nur eine Masse von 30 kg. Damit wird der zusätzliche Vorteil erzielt, daß die Einrichtung zur Überprüfung des Abschalt-Drehmomentes von einem Einsatzort zum anderen getragen werden kann.

Die Bremse ist beispielsweise eine Lamellenbremse. Solche Lamellenbremsen sind bekannt. Sie eignen sich besonders zum Abbremsen einer Welle.

Die Drehmoment-Meßwelle oder die Bremse können unmittelbar oder über einen Adapter mit der Abtriebswelle des Stellantriebes verbunden sein.

Beispielsweise sind die Bremse und die Drehmoment-Meßwelle von einem eine Öffnung aufweisenden Gehäuse umgeben. An der Öffnung des Gehäuses sind die Drehmoment-Meßwelle oder die Bremse mit der Abtriebswelle des Stellantriebes verbindbar. Durch ein solches Gehäuse sind Bremse und Drehmoment-Meßwelle vor äußeren Einwirkungen geschützt. Andererseits wird der Vorteil erzielt, daß die zur Überprüfung des Abschalt-Drehmomentes des Stellantriebes benötigte Einrichtung leicht handhabbar ist.

Das Gehäuse besteht beispielsweise aus einer der Öffnung gegenüberliegenden Grundplatte, aus auf dieser angeordneten Seitenwänden und aus einem die Öffnung umschließenden Flansch, der an ein Gehäuse des Stellantriebes angelegt werden kann. Ein solches Gehäuse für eine Kombination aud Drehmoment-Meßwelle und Bremse ist mit einfachen Verbindungen, beispielsweise durch Schrauben, mit seinem Flansch leicht am Gehäuse des Stellantriebes zu befestigen. Ebenso schnell kann das Gehäuse der Kombination vom Stellantrieb wieder abgenommen werden. Außer Schraubverbindungen sind auch andere Verbindungsmittel möglich. Das Anbringen des Gehäuses der Kombination wird erleichtert, wenn das Gehäuse des Stellantriebes entsprechende Vorrichtungen zum Befestigen des Gehäuses, das Drehmoment-Meßwelle und Bremse enthält, vorsieht. Die Vorrichtungen am Gehäuse des Stellantriebes können diejenigen Vorrichtungen sein, die während des Betriebes dazu dienen, den Stellantrieb an der Armatur arretiert zu halten.

Mit dem Gehäuse für die Kombination wird der Vorteil erzielt, daß die Kombination aus Drehmoment-Meßwelle und Bremse, die zur Überprüfung des Abschalt-Drehmomentes des Stellantriebes benötigt wird, leicht handhabbar ist und mit einem Stellantrieb schnell zu verbinden und auch wieder schnell von ihm zu lösen ist. Damit wird die für eine Überprüfung benötigte Stillstandszeit der Armatur weiter verkürzt.

Die Seitenwände des Gehäuses der Kombination können durch ein Rohr gebildet sein. Dadurch ist ein besonders einfacher und kostengünstiger Aufbau des Gehäuses gegeben.

Die Bremse ist beispielsweise mit einem Spannungsgeber zur Energieversorgung verbunden. Die Drehmoment-Meßwelle steht beispielsweise mit einer Auswerteeinheit in Verbindung zur Registrierung und Auswertung des Drehmomentverlaufes. Zumindest der Spannungsgeber aber auch die Auswerteeinheit können bereits vorhandene, der Anlage, deren Teil die Armatur ist, zugeordnete Einrichtungen sein.

Mit dem Verfahren und mit der Einrichtung nach der Erfindung wird insbesondere der Vorteil erzielt, daß allein mit bekannten käuflichen Geräten, nämlich einer Drehmoment-Meßwelle und einer Bremse, unmittelbar am Ort einer Armatur das Abschalt-Drehmoment des Stellantriebes dieser Armatur mit geringem technischem Aufwand schnell und zuverlässig zu überprüfen ist. Der Stellantrieb muß nicht in einen Werkstattraum gebracht werden, und es können sogar alle elektrischen Zuleitungen und Ableitungen des Stellantriebes bei der Überprüfung erhalten bleiben. Die Einrichtung kann wegen ihres geringen Gewichts in kurzer Zeit an verschiedenen Orten eingesetzt werden. Darüber hinaus wird der Vorteil erzielt, daß zur Prüfung die Anlagenverdrahtung benutzt werden kann und auch die Ansteuerung durch eine bereits vorhandene Steuereinrichtung der Armatur erfolgen kann.

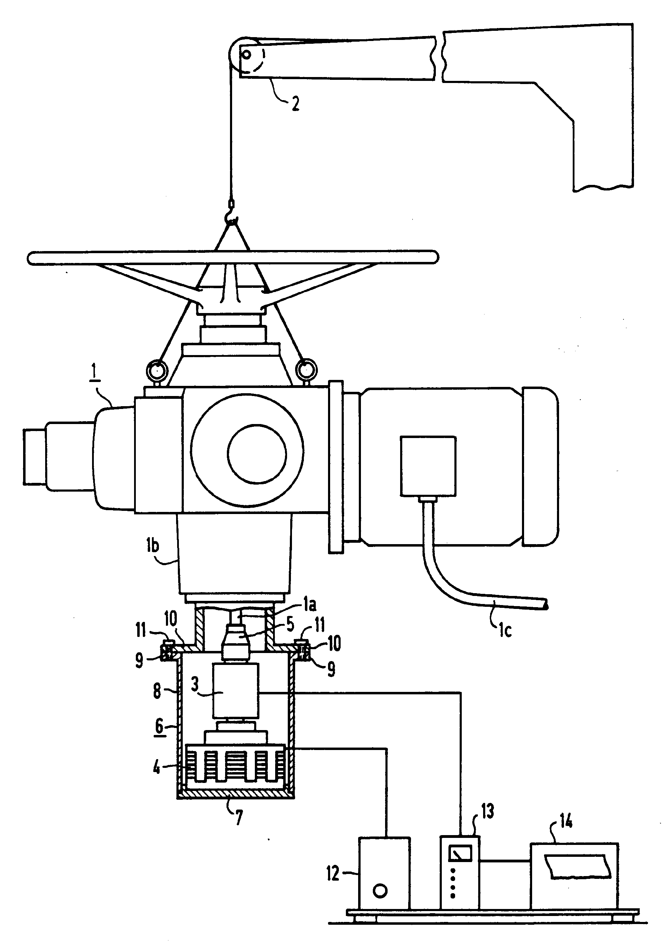

Die Erfindung wird anhand der Zeichnung näher erläutert: Die Zeichnung zeigt einen Stellantrieb, der mit einer Einrichtung zur Überprüfung des Abschalt-Drehmomentes verbunden ist.

Zur Überprüfung seines Abschalt-Drehmomentes ist ein Stellantrieb 1, der zuvor von einer Armatur abgetrennt worden ist, an einem Hebezeug 2 aufgehängt. Die Anlagenverdrahtung des Stellantriebes 1 mit der Armatur und mit anderen Bauteilen, insbesondere eine Zuleitung lc für den Motor des Stellenantriebes 1, ist dabei nicht unterbrochen. An der Stelle, an der der Stellantrieb 1 im Betriebszustand mit der Armatur verbunden ist, nämlich an einer Abtriebswelle la, ist an den Stellantrieb 1 eine Kombination aus einer Drehmoment-Meßwelle 3 und einer Bremse 4 angeschlossen. Die Drehmoment-Meßwelle 3 ist über einen Adapter 5 mit der Abtriebswelle la verbunden und steht ihrerseits mit der Bremse 4 in Verbindung. Angeordnet ist die Kombination aus Adapter 5, Drehmoment-Meßwelle 3 und Bremse 4 in einem Gehäuse 6. Das Gehäuse 6 besteht aus einer Grundplatte 7, einem auf ihr angeordneten Rohr 8 und einem an diesem angeformten Flansch 9. Der Flansch 9 liegt an entsprechenden Anformungen 10 an einem Gehäuse lb des Stellantriebes 1 an. Dort ist das Gehäuse 6 über Verbindungsmittel, beispielsweise über Schrauben 11 befestigt. Das Gehäuse 6 besteht beispielsweise aus Aluminium. Die Bremse 4 ist beispielsweise eine handelsübliche Lamellenbremse. Auch die Drehmoment-Meßwelle 3 ist ein handelsübliches Bauteil. Die Bremse 4 ist mit einem Spannungsgeber 12 verbunden. Die Drehmoment-Meßwelle 3 steht über einen Verstärker 13 mit einer Auswerteeinheit 14 in Verbindung, die mit einem Schreiber ausgestattet ist.

Zur Überprüfung des Abschalt-Drehmomentes des Stellantriebes 1 and der Abtriebswelle 1a wird der Stellantrieb 1 von der Armatur abgebaut. Alle elektrischen Verbindungen des Stellantriebes 1 mit anderen Komponenten können dabei erhalten bleiben. An die Abtriebswelle la des Stellantriebes 1 wird, während er z. B. an einem Hebezeug 2 hängt, die Kombination aus Drehmoment-Meßwelle 3 und Bremse 4 angeschlossen. Der Stellantrieb 1 wird dann durch das übliche Betriebssystem in Bewegung gesetzt. Das ist möglich, da weder ein Leistungskabel noch ein Steuerkabel vom Stellantrieb 1 abgetrennt werden muß. Nach dem Ansteuern des Stellantriebes 1 erfolgt ein Abbremsen über die Bremse 4. Der Drehmomentverlauf wird bei diesem Abbremsvorgang von der Drehmoment-Meßwelle 3 erfaßt und in der Auswerteeinheit 14 registriert und ausgewertet. Der Drehmomentverlauf wird überwacht bis der Stellantrieb 1 durch einen im Stellantrieb 1 integrierten bekannten Drehmoment-Endschalter abgeschaltet wird.

Das geschilderte Verfahren ist mit der genannten Einrichtung in der Nähe der Armatur durchführbar, wobei Verbindungsleitungen des Stellantriebes 1 mit anderen Bauteilen, insbesondere die Energieversorgung des Stellantriebes 1, nicht unterbrochen zu werden brauchen. Es ist in sehr kurzer Zeit eine Überprüfung des Abschalt-Drehmomentes des Stellantriebes 1 durchführbar. Damit ist die notwendige Stillstandszeit der Armatur und damit auch einer größeren Anlage, wie beispielsweise eines Kraftwerkes, sehr klein.

## Patentansprüche

1. Verfahren zur Überprüfung des Abschalt-Drehmomentes eines Stellantriebes (1) einer Armatur, der eine Abtriebswelle (la) für die Armatur und einen Drehmoment-Endschalter aufweist, **dadurch gekennzeichnet**, daß der Stellantrieb (1) unter Beibehaltung mindestens einer elektrischen Leitung (1c), die am Stellantrieb (1) endet oder von ihm ausgeht, von der Armatur abgehoben wird, daß mit der Abtriebswelle (1a) des Stellantriebs (1) eine Drehmoment-Meßwelle (3) und eine mit ihr verbundene Bremse (4) verbunden wird, daß der Stellantrieb (1) in unmittelbarer Nähe der Armatur in Betrieb genommen wird und anschließend bis zum Ansprechen des Drehmoment-Endschalters abgebremst wird, und daß das dabei ermittelte Abschalt-Drehmoment mit einem Soll-Abschalt-Drehmoment verglichen wird.

2. Verfahren nach Anspruch 1,
**dadurch gekennzeichnet**, daß bis zum Ansprechen des Drehmoment-Endschalters der Verlauf des Drehmomentes gemessen und registriert wird.

3. Verfahren nach einem der Ansprüche 1 oder 2,
**dadurch gekennzeichnet,** daß der Stellantrieb (1) an einem Hebezeug (2) hängend von der Armatur abgehoben und hängend gehalten und in Betrieb genommen wird.

4. Verfahren nach einem der Ansprüche 1 oder 2,
**dadurch gekennzeichnet**, daß der Stellantrieb (1) von der Armatur abgehoben und mit nach oben gerichteter Abtriebswelle (1a) positioniert und in Betrieb genommen wird.

5. Einrichtung zur Überprüfung des Abschalt-Drehmomentes eines Stellantriebes (1) einer Armatur, der eine Abtriebswelle (1a) für die Armatur und einen Drehmoment-Endschalter aufweist, mit dem Verfahren nach einem der Ansprüche 1 bis 4, **dadurch gekennzeichnet**, daß mit der Abtriebswelle (1a) des von der Armatur getrennten Stellantriebes (1) eine Drehmoment-Meßwelle (3), die mit einer Bremse (4) verbunden ist, oder eine Bremse (4), die mit einer Drehmoment-Meßwelle (3) verbunden ist, in unmittelbarer Nähe der Armatur verbunden ist und daß mindestens eine elektrische Leitung (1c), die am Stellantrieb (1) endet oder von ihm ausgeht, beibehalten bleibt.

6. Einrichtung nach Anspruch 5,
**dadurch gekennzeichnet**, daß die Bremse (4) eine Lamellenbremse ist.

7. Einrichtung nach einem der Ansprüche 5 oder 6,
**dadurch gekennzeichnet**, daß die Bremse (4) oder die Drehmoment-Meßwelle (3) mit der Abtriebswelle (1a) über einen Adapter (5) verbindbar sind.

8. Einrichtung nach einem der Ansprüche 5 bis 7,
**dadurch gekennzeichnet**, daß die Bremse (4) und die Drehmoment-Meßwelle (3) von einem eine Öffnung aufweisenden Gehäuse (6) umgeben sind, an dessen Öffnung die Drehmoment-Meßwelle (3) oder die Bremse (4) mit der Abtriebswelle (1a) des Stellantriebes (1) verbindbar sind.

9. Einrichtung nach Anspruch 8,
**dadurch gekennzeichnet**, daß das Gehäuse (6) aus einer der Öffnung gegenüberliegenden Grundplatte (7), aus auf dieser angeordneten Seitenwänden und aus einem die Öffnung umschließenden, an den Seitenwänden angeformten Flansch (9), der an ein Gehäuse (1b) des Stellantriebes (1) anschließbar ist, besteht.

10. Einrichtung nach Anspruch 9,
**dadurch gekennzeichnet**, daß die Seitenwände durch ein Rohr (8) gebildet sind.

11. Einrichtung nach einem der Ansprüche 5 bis 10,
**dadurch gekennzeichnet**, daß die Bremse (4) mit einem Spannungsgeber (12) in Verbindung steht.

12. Einrichtung nach einem der Ansprüche 5 bis 11,
**dadurch gekennzeichnet**, daß die Drehmoment-Meßwelle (3) mit einer Auswerteeinheit (14) in Verbindung steht.

## Claims

1. Method for verifying the cut-off torque of an actuator (1) of an armature, the actuator having a drive shaft (1a) for the armature and a torque limit switch, characterised in that the actuator (1) is lifted away from the armature with the retention of at least one electrical lead (1c) which terminates at the actuator (1) or starts therefrom, in that, to the drive shaft (1a) of the actuator (1), there is connected a torque measuring shaft (3) and a brake (4) connected thereto, in that the actuator (1) is operated in the immediate vicinity of the armature and is subsequently braked until the torque limit switch responds, and in that the cut-off torque thus determined is compared with a setpoint cut-off torque.

2. Method according to claim 1, characterised in that the characteristic of the torque is measured and recorded until the torque limit switch responds.

3. Method according to one of claims 1 or 2, characterised in that the actuator (1) is suspended from hoisting gear (2) and lifted away from the armature and operated whilst held suspended.

4. Method according to one of claims 1 or 2, characterised in that the actuator (1) is lifted away from the armature and positioned with the drive shaft (1a) pointing upwards while the actuator (1) is operated.

5. Device for verifying the cut-off torque of an actuator (1) of an armature, which actuator has a drive shaft (1a) for the armature and a torque limit switch, using the method according to one of claims 1 to 4, characterised in that a torque measuring shaft (3) connected to a brake (4) or a brake (4) connected to a torque measuring shaft (3) is connected in the immediate vicinity of the armature to the drive shaft (1a) of the actuator (1), the actuator being separated from the armature,, and in that at least one electrical lead (1c) which terminates at the actuator (1) or starts therefrom, is retained.

6. Device according to claim 5, characterised in that the brake (4) is a multiple-disc brake.

7. Device according to one of claims 5 or 6, characterised in that the brake (4) or the torque measuring shaft (3) can be connected to the drive shaft (1a) by way of an adaptor (5).

8. Device according to one of claims 5 to 7, characterised in that the brake (4) and the torque measuring shaft (3) are surrounded by a housing (6) having an opening, at which opening the torque measuring shaft (3) or the brake (4) can be connected to the drive shaft (1a) of the actuator (1).

9. Device according to claim 8, characterised in that the housing (6) comprises a base plate (7) located opposite the opening, side walls arranged on this base plate (7) and a flange (9) pre-formed on the side walls and surrounding the opening, which flange (9) can be attached to a housing (1b) of the actuator (1).

10. Device according to claim 9, characterised in that the side walls are formed by a pipe (8).

11. Device according to one of claims 5 to 10, characterised in that the brake (4) is connected to a voltage sensor (12).

12. Device according to one of claims 5 to 11, characterised in that the torque measuring shaft (3) is connected to an evaluation unit (14).

## Revendications

1. Procédé pour contrôler le couple de débranchement d'un servomoteur (1) d'un robinet, qui comporte un arbre mené (1a) pour le robinet et un interrupteur de fin de course pour le couple, caractérisé en ce qu'il consiste à soulever le servomoteur (1) du robinet tout en conservant au moins une ligne électrique (1c), qui se termine au servomoteur (1) ou qui en part, à relier l'arbre mené (1a) du servomoteur (1) un arbre (3) de mesure du couple et à un frein (4) relié à cet arbre, à mettre le servomoteur (1) en service à proximité immédiate du robinet et ensuite à le freiner jusqu'à ce que l'interrupteur de fin de course pour le couple réagisse, et à comparer le couple de débranchement ainsi déterminé à un couple de débranchement de consigne.

2. Procédé suivant la revendication 1, caractérisé en ce qu'il consiste à mesurer et à enregistrer la variation du couple jusqu'à la réaction de l'interrupteur de fin de course pour le couple.

3. Procédé suivant l'une des revendications 1 ou 2, caractérisé en ce qu'il consite à soulever du robinet le servomoteur (1) en le suspendant à un outil de levage (2) et à le maintenir suspendu et à le mettre en fonctionnement.

4. Procédé suivant l'une des revendications 1 ou 2, caractérisé en ce qu'il consiste à soulever le servomoteur (1) du robinet et à le mettre en position de fonctionnement, avec l'arbre mené (1a) dirigé vers le haut.

5. Dispositif pour contrôler le couple de débranchement d'un servomoteur (1) d'un robinet, qui comporte un arbre mené (1a) pour le robinet et un interrupteur de fin de course pour le couple, par le procédé selon l'une des revendications 1 à 4, caractérisé par le fait qu'à l'arbre mené (1a) du servomoteur (1) séparé du robinet est relié un arbre (3) de mesure du couple, qui est relié à un frein (4), ou un frein (4), qui est relié à un arbre (3) de mesure du couple, est relié à proximité immédiate du robinet et qu'au moins une ligne électrique (lc), qui se termine dans le servomoteur (1) ou en part, reste conservé.

6. Dispositif suivant la revendication 5, caractérisé par le fait que le frein est un frein à disques.

7. Dispositif suivant l'une des revendications 5 ou 6, caractérisé par le fait que le frein (4) ou l'arbre (3) de mesure du couple peuvent être reliés à l'arbre mené (1a) par l'intermédiaire d'un adaptateur (5).

8. Dispositif suivant l'une des revendications 5 à 7, caractérisé par le fait que le frein (4) et l'arbre de mesure (3) du couple sont entourés d'un boîtier (6) ayant une ouverture, dans laquelle l'arbre (3) de mesure du couple ou le frein (4) peut être relié à l'arbre mené (1a) du servomoteur (1).

9. Dispositif suivant la revendication 8, caractérisé par le fait que le boîtier (6) est constitué d'une plaque de base (7), qui est en regard de l'ouverture, de parois latérales montées sur cette plaque de base, et d'une bride (9) qui entoure l'ouverture qui est issue des parois latérales et qui peut être raccordée à un boîtier (1b) du servomoteur (1).

10. Dispositif suivant la revendication 9, caractérisé par le fait que les parois latérales sont formées par un tube (8).

11. Dispositif suivant l'une des revendications 5 à 10, caractérisé par le fait que le frein (4) est relié à un générateur de tension (12).

12. Dispositif suivant l'une des revendications 5 à 11, caractérisé par le fait que l'arbre (3) de mesure du couple est relié à une unité d'exploitation (14).
